(19) Europäisches Patentamt / European Patent Office / Office européen des brevets

(11) **EP 2 626 678 B1**

(12) **EUROPEAN PATENT SPECIFICATION**

(45) Date of publication and mention
of the grant of the patent:
**15.07.2020   Bulletin 2020/29**

(51) Int Cl.:
*G01L 3/10* *(2006.01)*
*G01L 3/14* *(2006.01)*
*H01L 41/12* *(2006.01)*
*H01F 7/02* *(2006.01)*

(21) Application number: **13154425.6**

(22) Date of filing: **07.02.2013**

(54) **Magnetic torque sensor for transmission converter drive plate**

Magnetischer Drehmomentsensor für Übertragungskonverter-Antriebsplatte

Détecteur de couple magnétique pour plaque d'entraînement de convertisseur de transmission

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **07.02.2012   US 201213368079**

(43) Date of publication of application:
**14.08.2013   Bulletin 2013/33**

(73) Proprietor: **Methode Electronics, Inc.
Chicago, IL 60706 (US)**

(72) Inventor: **Lee, Seong-Jae
Mount Prospect, IL 60056 (US)**

(74) Representative: **Prinz & Partner mbB
Patent- und Rechtsanwälte
Rundfunkplatz 2
80335 München (DE)**

(56) References cited:
**EP-A1- 2 584 331       WO-A1-01/13082
US-A- 5 083 359       US-A1- 2009 230 953
US-B1- 6 513 395**

# Description

## CROSS-REFERENCE TO RELATED APPLICATIONS

This patent application is a continuation-in-part of and is related to and claims priority to U.S. Patent Application No. 13/275,693, filed October 18, 2011.

## BACKGROUND OF THE INVENTION

### Field of Invention

The present invention relates to sensing devices for automotive transmissions and, more particularly, to non-contacting magnetoelastic torque sensors for providing a measure of the torque transmitted radially in a transmission converter drive plate or similar disk-shaped member.

### Description of the Related Art

In the control of systems having rotating drive shafts, torque and speed are fundamental parameters of interest. Therefore, the sensing and measurement of torque in an accurate, reliable, and inexpensive manner has long been a primary objective of such control system designs.

Previously, torque measurement was accomplished using contact-type sensors directly attached to a shaft. One such sensor is a "strain gauge" type torque detection apparatus, in which one or more strain gauges are directly attached to the outer peripheral surface of the shaft and a change in resistance caused by torque-induced strain is measured by a bridge circuit or other well known means. However, contact-type sensors are relatively unstable and of limited reliability due to the direct contact with the rotating shaft. In addition, they are expensive and are thus commercially impractical for competitive use in many applications, such as automotive steering systems, for which torque sensors are sought.

Subsequently, non-contact torque sensors of the magnetostrictive type were developed for use with rotating shafts. For example, U.S. Pat. No. 4,896,544 to Garshelis, discloses a sensor comprising a torque-carrying member, with an appropriately ferromagnetic and magnetostrictive surface, two axially distinct circumferential bands within the member that are endowed with respectively symmetrical, helically-directed residual stress-induced magnetic anisotropy, and a magnetic discriminator device for detecting, without contacting the torqued member, differences in the response of the two bands to forces applied to the torque-carrying member. Most typically, magnetization and sensing are accomplished by providing a pair of excitation or magnetizing coils overlying and surrounding the bands, with the coils connected in series and driven by alternating current. Torque is sensed using a pair of oppositely connected sensing coils for measuring a difference signal resulting from the external magnetic fluxes of the two bands. Unfortunately, providing sufficient space for the requisite excitation and sensing coils on and around the device on which the sensor is used can create practical problems in applications where space is at a premium. Also, such sensors may be impractically expensive for use on highly cost-competitive devices, such as in automotive applications.

Torque transducers based on measuring the field arising from the torque induced tilting of initially circumferential remanent magnetizations have been developed which, preferably, utilize a thin wall ring ("collar") serving as the field generating element. See, for example, U.S. Pat. Nos. 5,351,555 and 5,520,059 to Garshelis. Tensile "hoop" stress in the ring, associated with the means of its attachment to the shaft carrying the torque being measured establishes a dominant, circumferentially directed, uniaxial anisotropy. Upon the application of torsional stress to the shaft, the magnetization reorients and becomes increasingly helical as torsional stress increases. The helical magnetization resulting from torsion has both a radial component and an axial component, the magnitude of the axial component depending entirely on the degree of torsion. One or more magnetic field vector sensors may be used to sense the magnitude and polarity of the field arising, as a result of the applied torque, in the space above the magnetically conditioned regions on a shaft, and provide a signal output reflecting the magnitude and direction of the torque. Inasmuch as the peak allowable torque in a ring sensor is limited by slippage at the ring/shaft interface, concerns have been expressed regarding distortion arising from slippage at the ring/shaft interface under conditions of torque overload. This, together with the need for multiple parts of different materials to minimize the adverse effects of parasitic fields, has encouraged the investigation of alternative constructions.

Magnetoelastic torque transducers have been developed in which the active, torque sensing region is formed directly on the shaft itself, rather than on a separate ferromagnetic element which then has to be affixed to the shaft. See, for example, U.S. Pat. No. 6,047,605 to Garshelis. In one form of these so-called "collarless" transducers, the magnetoelastically active region is polarized in a single circumferential direction and itself possesses sufficient magnetic anisotropy to return the magnetization in the region, following the application of torque to the member, to the single circumferential direction when the applied torque is reduced to zero. The torqued shaft is desirably formed of a polycrystalline material wherein at least 50% of the distribution of local magnetizations lie within a 90-degree quadrant symmetrically disposed around the direction of magnetic polarization and have a coercivity sufficiently high that the transducing region field does not create parasitic magnetic fields in proximate regions of the shaft of sufficient strength to destroy the usefulness, for torque sensing purposes, of the net magnetic field seen by the magnetic field sensor. In particularly preferred forms of such transducers the shaft is formed of a randomly oriented, polycrystalline material having cubic symmetry and the coercivity is greater than 15 Oersted (Oe), desirably greater than 20 Oe and, preferably, greater than 35 Oe.

More recently, non-contacting magnetoelastic torque sensors have been developed that provide signals indicative of the torque transmitted between radially separated locations of disk-shaped members. U.S. Pat. No. 6,513,395 to Jones, describes a torque sensor that includes a disk-shaped member having a magnetoelastically active region that is polarized in a single circumferential direction. In that patent, a magnetic field sensor is mounted proximate to the active region, the sensor sensing the magnitude of a magnetic field resulting from a torque transferred from a shaft to the disk-shaped member, and the sensor outputting a signal in response thereto. Such a configuration may be susceptible to compassing as discussed below. That patent also describes a disk having dual circumferentially and oppositely polarized regions, with two sensors positioned along the same radial line, their sensitive directions oriented radially and oppositely to permit common mode field cancellation. This placement of sensors, however, has the undesired result in which the sensors pick up magnetic field signals that do not change linearly in response to a change in torque applied to the disk.

Other prior art, such as patent WO 01/13082 A1 to May, describes a torque sensor that includes a disk-shaped member having a region in which annular magnetically conditioned regions are separated from one another and spaced in a radial direction. It is believed, however, that a torque sensor having a gap between magnetically conditioned regions may exhibit a large rotational signal uniformity (RSU) signal due to random magnetic leakage fields between the two annular magnetically conditioned regions. Ideally, a torque sensor will exhibit a zero RSU signal, which is defined as no variation in signal output during the rotation of a member when no torque, or a constant torque, is applied to the rotating member. In actual practice however, due to deficiencies in the surface preparation and magnetization processes, noticeable RSU signals are detected. Furthermore, a torque sensor having a disk-shaped member with a gap between magnetically conditioned regions requires additional space, which is not desirable in applications in which the disk has a limited amount of flat surface available for magnetically conditioned regions.

Because magnetic fields, in the context of their measurement, are fungible, the sensors taught by the above and other prior art may be susceptible to other magnetic fields of exterior origin. In particular, the earth's magnetic field will cause a phenomenon known as "compassing," in which the measured field is the sum of the torque induced magnetic field and the earth's magnetic field. Within the context of this disclosure, the term "compassing" shall be used to describe any error resulting from the earth's magnetic field.

Magnetic fields of external origin can emanate from both far field and near field sources. A far field source, such as the earth with its magnetic field, generally has the same effect on each magnetic field sensor in a torque sensing device having multiple magnetic field sensors. Near field sources, such as permanent magnets, magnetized wrenches, motors, solenoids, etc., may create magnetic fields having significant local gradients, thus having significantly different effects on the different magnetic field sensors in a torque sensing device having multiple magnetic field sensors.

U.S. Pat. No. 5,520,059 to Garshelis addresses the compassing issue with respect to far field sources. In that patent, a shaft is described having two axially distinct magnetoelastically active regions, polarized in opposite circumferential directions, with magnetic field sensors having opposite axial polarities positioned proximate to the active regions and providing output signals in response to a torque applied to the shaft. By summing the outputs of the magnetic field sensors, all common mode external magnetic fields, i.e. far fields, are canceled. In applications employing such a scheme, the oppositely polarized sensors should be placed as close to each other as possible to preserve the efficiency of the common mode rejection scheme. Sensors that are spaced from one another exhibit reduced common mode rejection efficiency, as the earth's magnetic field may be significantly distorted around ferromagnetic parts in and around the torque sensor.

U.S. Pat. App. Pub. No. 2009/0230953 to Lee, describes a torque sensing device designed to cancel near field magnetic noise from external sources without canceling a torque-induced magnetic field. That reference describes a torque sensor including three sets of magnetic field sensors, axially spaced proximate to a shaft, the shaft having a magnetoelastically active region that is polarized in a circumferential direction. Signals received by each of the magnetic field sensors are adjusted to compensate for the effects of near field sources.

In torque sensing devices having ferromagnetic members with annular magnetoelastically active regions, it is desirable for a magnetic field sensor placed proximate to the magnetoelastically active region to pick up a signal that accurately represents the torque applied to the member, regardless of the angular distance between the magnetic field sensor and a radius of the member. Torque sensing devices that demonstrate this characteristic are said to demonstrate improved rotational signal uniformity (RSU). Non-uniformities in the depth, width, or magnetic field strength, about an annular magnetoelastically active region may lead to noticeable RSU signals and, hence, inaccurate torque measurements. Improved RSU performance, and a decreased hysteresis effect, may also be achieved by subjecting the ferromagnetic member to an appropriate surface hardness process, as is known in the art, prior to magnetization. Lee, for example describes a torque sensing device designed to exhibit improved RSU performance by incorporating a plurality of angularly and axially spaced magnetic field sensors placed proximate to a circumferential surface of a rotatable shaft.

The torque sensing devices described in the prior art are not specially configured for measuring the torque transmitted between a shaft and a radially separated portion of a disk-shaped member, while demonstrating improved RSU performance and reducing detrimental effects caused by compassing. Accordingly, there exists a need for such a device.

## SUMMARY OF THE INVENTION

The present invention, as described herein, is generally applicable to the measurement of torque in any disk-shaped member that is rotatable about an axis, such as a pulley, gear, sprocket, or the like.

It is a principal object of the present invention to provide a torque sensing device having non-contacting magnetic field sensors positioned proximate to a disk-shaped member, for measuring the torque transmitted between a shaft and a radially separated portion of the disk-shaped member.

It is another object of the invention to provide a torque sensing device having magnetic field sensors that output a signal representative of an applied torque, wherein the output signal varies linearly with respect to variations in the applied torque.

It is another object of the present invention to provide a torque sensing device having magnetic field sensors placed in pairs, the magnetic field sensors having their sensing directions opposite one another, to minimize the detrimental effects of magnetic noise, including compassing.

It is another object of the present invention to provide a torque sensing device with an annular magnetoelastically active region, having dual, non-separated, oppositely polarized magnetically conditioned regions to enhance the RSU performance of the torque sensing device.

It is another object of the present invention to provide a torque sensing device with multiple, angularly-spaced magnetic field sensors that are specially positioned to enhance the RSU performance of the torque sensing device.

Briefly described, those and other objects, advantages, and features of the present invention are accomplished, as embodied and fully described herein, by a magnetic torque sensing device according to the subject matter of claim 1.

The magnetically conditioned regions of the device are annularly shaped with no gap therebetween to increase the accuracy of the torque sensing device. The device includes multiple pairs of magnetic field sensors to increase accuracy. The magnetic field sensors may be circumferentially oriented when magnetically conditioned regions are axially polarized, and axially oriented when magnetically conditioned regions are circumferentially polarized to enhance the linear performance of the device and to increase accuracy.

With those and other objects, advantages, and features of the invention that may become hereinafter apparent, the nature of the invention may be more clearly understood by reference to the following detailed description of the invention, the appended claims and to the several drawings attached herein.

## BRIEF DESCRIPTION OF THE DRAWINGS

FIG. 1 is a perspective view of a disk-shaped member according to the present invention.

FIG. 2 is a side elevation view of the disk-shaped member of FIG. 1, depicting the magnetization of a magnetoelastic active region, according to an embodiment of the present invention.

FIG. 3 is a top plan view of the disk-shaped member of FIG. 2, depicting the magnetization of a magnetoelastic active region, according to an embodiment of the present invention.

FIG. 4A is a graph illustrating the strengths of the magnetic fields in the magnetically conditioned regions when the torque sensing device of the present invention is in a quiescent state.

FIG. 4B is a top plan view of a disk-shaped member according to the present invention, illustrating the relationship between the disk-shaped member and the graph of FIG. 4A.

FIG. 5 is a top plan view of a disk-shaped member, showing illustrative positionings of magnetic field sensors, not belonging to the present invention.

FIG. 6 is a top plan view of a disk-shaped member, showing illustrative positionings of magnetic field sensors, not belonging to the present invention.

FIG. 7 is a top plan view of a disk-shaped member, showing illustrative positionings of magnetic field sensors, according to an embodiment of the present invention.

FIG. 8 is a top plan view of a disk-shaped member, showing illustrative positionings of magnetic field sensors, not belonging to the present invention.

FIG. 9A is a top plan view of a disk-shaped member, showing illustrative positionings of magnetic field sensors, not belonging to the present invention.

FIG. 9B is a top plan view of a disk-shaped member, showing illustrative positionings of magnetic field sensors, not belonging to the present invention.

FIG. 9C is a top plan view of a disk-shaped member, showing illustrative positionings of magnetic field sensors, not belonging to the present invention.

FIG. 9D is a top plan view of a disk-shaped member, showing illustrative positionings of magnetic field sensors, not belonging to the present invention.

FIG. 9E is a top plan view of a disk-shaped member, showing illustrative positionings of magnetic field sensors, not belonging to the present invention.

**FIG. 9F** shows experimental data obtained from tests conducted on the configuration shown in **FIG. 9C**.

**FIG. 9G** shows experimental data obtained from tests conducted on the configuration shown in **FIG. 9C**.

**FIG. 10** is a perspective view of a disk-shaped member according to elements of the present invention illustrating a change in the magnetization of the magnetoelastically active region when the disk-shaped member is subjected to torque.

**FIG. 11** is an exploded view showing an exemplary torque sensing device according to the present invention for use in an automotive drive train.

**FIG. 12** is a perspective view showing a bobbin with shielding members for use with a torque sensing device according to the present invention

## DETAILED DESCRIPTION OF THE PREFERRED EMBODIMENTS

Several preferred embodiments of the invention are described for illustrative purposes, it being understood that the invention may be embodied in other forms not specifically shown in the drawings. The figures herein are provided for exemplary purposes and are not drawn to scale.

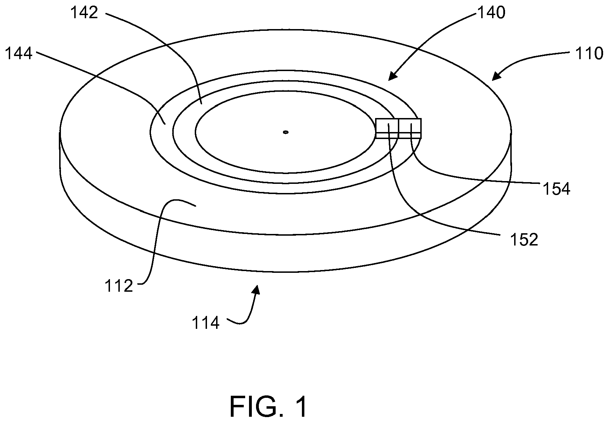

Turning first to FIG. 1, shown therein is a perspective drawing of a generally disk-shaped member 110 in accordance with the torque sensing device of the present invention. The disk 110 is formed of ferromagnetic material and is, or at least includes, a magnetoelastically active region 140. The material selected for forming the disk 110 must be at least ferromagnetic to ensure the existence of magnetic domains for at least forming a remanent magnetization in the magnetoelastically active region 140, and must be magnetostrictive such that the orientation of magnetic field lines in the magnetoelastically active region 140 may be altered by the stresses associated with applied torque. The disk 110 may be completely solid, or may be partially hollow. The disk 110 may be formed of a homogeneous material or may be formed of a mixture of materials. The disk 110 may be of any thickness, and is preferably between about 3 mm and about 1 cm thick.

The magnetoelastically active region 140 is preferably flat, and comprises at least two radially distinct, annular, oppositely polarized magnetically conditioned regions 142, 144, defining the magnetoelastically active region 140 of the torque sensing device. The top and bottom surfaces 112, 114 do not have to be flat, however, as shown, but could have variable thickness in cross-section from the center of the disk 110 to the outer edge. Depending on the application for which the torque sensing device is desired, it may be impractical to position magnetic field sensors 152, 154 on both sides of the disk 110. Therefore, the present invention is designed to function in instances where the magnetoelastically active region 140 is present on only one surface of the disk 110. However, the magnetoelastically active region 140 may be present on both sides of the disk 110.

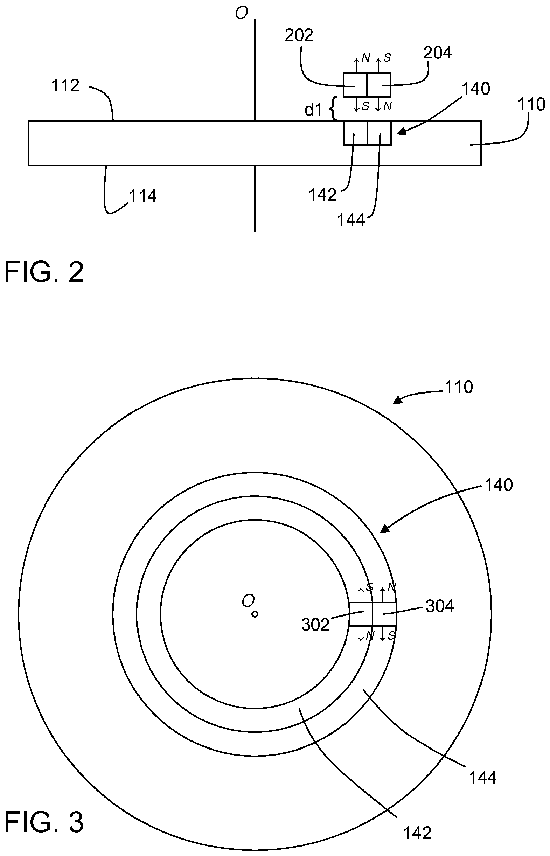

FIG. 2 shows a side view of the disk 110, and illustrates a process by which the magnetoelastically active region 140 may be formed on an annular portion of the disk 110. As shown, two permanent magnets 202, 204, having opposite directions of magnetization (and thus opposite polarity), are positioned proximate to the surface of the disk 110 at a distance d1. Following the positioning of the permanent magnets 202, 204, the disk 110 may be rotated about its central axis O, resulting in the formation of two annular, oppositely polarized, magnetically conditioned regions 142, 144. Alternatively, the magnetically conditioned regions 142, 144 may be formed by rotating the permanent magnets about the central axis O, while the disk 110 remains stationary. During creation of the magnetoelastically active region 140, the speed of rotation about the central axis O, and the distance d1 between the permanent magnets 202, 204 and the surface of the disk 110, should be kept constant to ensure uniformity of the magnetoelastically active region 140 and improve the RSU performance of the torque sensing device. Preferably, during the creation of the magnetoelastically active region 140, the permanent magnets 202, 204 are positioned adjacent to one another, with no gap therebetween, to form magnetically conditioned regions 142, 144 with no gap therebetween. The absence of a gap between the magnetically conditioned regions 142, 144 is understood to result in a torque sensing device with improved RSU performance.

In forming the magnetoelastically active region 140, the strength of the permanent magnets 202, 204, and the distance d1 between the permanent magnets 202, 204 and the disk 110, must be carefully selected to optimize performance of the torque sensing device. By using stronger permanent magnets 202, 204, and by positioning permanent magnets 202, 204 closer to the disk 110, one can generally produce a magnetoelastically active region 140 that will provide a stronger, more easily measurable signal, when employed by a torque sensing device. However, by using permanent magnets 202, 204 that are excessively strong, or by placing permanent magnets 202, 204 excessively close to the disk 110, one can produce a magnetoelastically active region 140 that exhibits hysteresis, which negatively affects the linearity of the signal produced by the torque sensing device in response to an applied torque. Preferably, the magnetoelastically conditioned region 140 is created using rectangular N42 or N45 grade neodymium iron boron (NdFeB) magnets placed at a distance of between about 0.1 mm and 5 mm from the surface of the disk 110. More preferably, magnets are placed at a distance of about 3 mm from the surface of the disk 110. Preferably, the width of the magnetoelastically active region 140 is not greater than 13 mm. More preferably, the width of the magnetoelastically active region 140 is about 10 mm.

FIG. 2 shows an embodiment having permanent magnets 202, 204 with directions of magnetization that are perpendicular to the plane of the disk 110. This configuration results in magnetically conditioned regions 142, 144 that are initially polarized in the axial direction (i.e., perpendicular to the disk surface). In this configuration, the magnetically conditioned regions 142, 144 are preferably polarized such that, in the absence of torque applied to the disk 110 (i.e., when the torque sensing device is in the quiescent state), the magnetically conditioned regions 142, 144 have no net magnetization components in the circumferential or radial directions.

During formation of the magnetoelastically active region 140, the permanent magnets 202, 204 may be positioned, as shown in FIG. 2, such that the innermost magnetically conditioned region 142 is created with its magnetic north pole directed upward, and the outermost magnetically conditioned region 144 is created with its magnetic north pole directed downward. Alternatively, during formation of the magnetoelastically active region 140, the permanent magnets may be positioned such that the innermost magnetically conditioned region 142 is created with its magnetic north pole directed downward, and the outermost magnetically conditioned region 144 is created with its magnetic north pole directed upward.

FIG. 3 shows a top view of the disk 110, and illustrates an embodiment in which the magnetoelastically active region 140 is created with permanent magnets 302, 304 having directions of magnetization that are parallel to the plane of the disk 110, in the circumferential direction. This configuration results in magnetically conditioned regions 142, 144 that are initially polarized in the circumferential direction of the disk 110. In this configuration, the magnetically conditioned regions 142, 144 are preferably polarized such that, in the absence of torque applied to the disk 110, the magnetically conditioned regions 142, 144 have no net magnetization components in the axial or radial directions.

During formation of the magnetoelastically active region 140, the permanent magnets 302, 304 may be positioned, as shown in FIG. 3, such that the innermost magnetically conditioned region 142 is created with its magnetic north pole having a clockwise orientation, and the outermost magnetically conditioned region 144 is created with its magnetic north pole having a counter-clockwise orientation. Alternatively, during formation of the magnetoelastically active region, the permanent magnets 302, 304 may be positioned such that the innermost magnetically conditioned region 142 is created with its magnetic north pole having a counter-clockwise orientation, and the outermost magnetically conditioned region 144 is created with its magnetic north pole having a clockwise orientation.

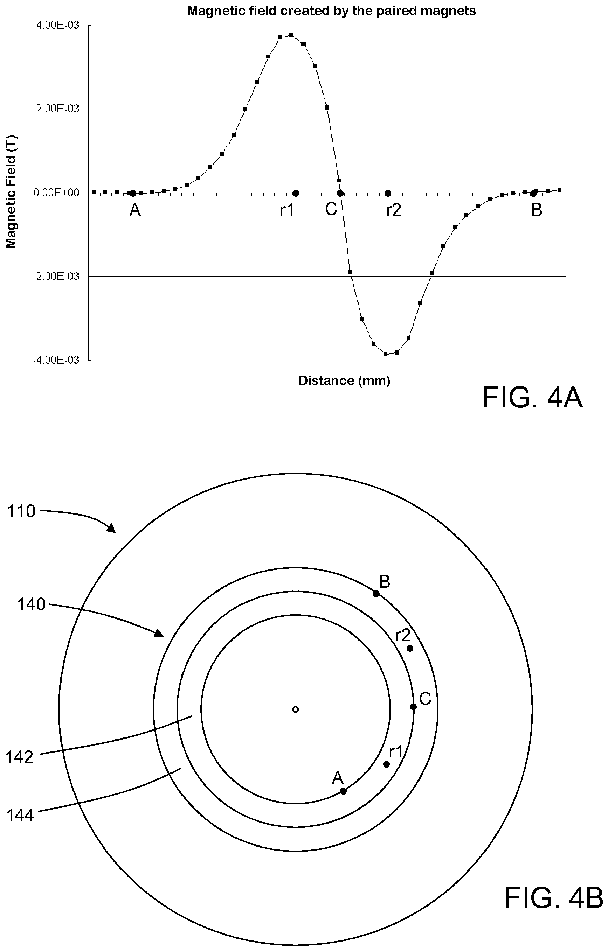

Turning to FIGS. 4A and 4B, FIG. 4A is a graph illustrating the strength of the magnetic fields in the magnetically conditioned regions 142, 144 when the torque sensing device is in the quiescent state. Values along the vertical axis represent the magnetic field strength of the magnetoelastically active region 140. The magnetic fields emanating from the surface of the disk 110 may have their principle components in the axial direction, as with the disk 110 of FIG. 2, or in the circumferential direction, as with the disk 110 of FIG. 3. Values along the horizontal axis represent distance along a radius of the disk 110 from the center line O to the outer edge of the disk 110. Point A corresponds to a point along the edge of the innermost magnetically conditioned region 142 nearest the center of the disk 110. Point B corresponds to a point along the edge of the outermost magnetically conditioned region 144 nearest the circumferential edge of the disk 110. Point C corresponds to a point along the boundary between the innermost and outermost magnetically conditioned regions 142, 144. Point r1 corresponds to a point within the innermost magnetically conditioned region 142, at which the magnetic field strength is at a maximum. Point r2 corresponds to a point within the outermost magnetically conditioned region 144, at which the magnetic field strength is at a maximum. FIG. 4B shows the disk 110 with points A, B, C, r1, and r2 corresponding to those points shown in the graph of FIG. 4A. Points r1 and r2, corresponding to the peak magnetic fields, indicate the distances from the center of the disk 110 at which magnetic field sensors 152, 154 should be placed to optimize the direction of the external magnetic flux, and hence maximize the performance of the torque sensing device. The units provided in FIG. 4 are for exemplary purposes and are not limiting on the present invention.

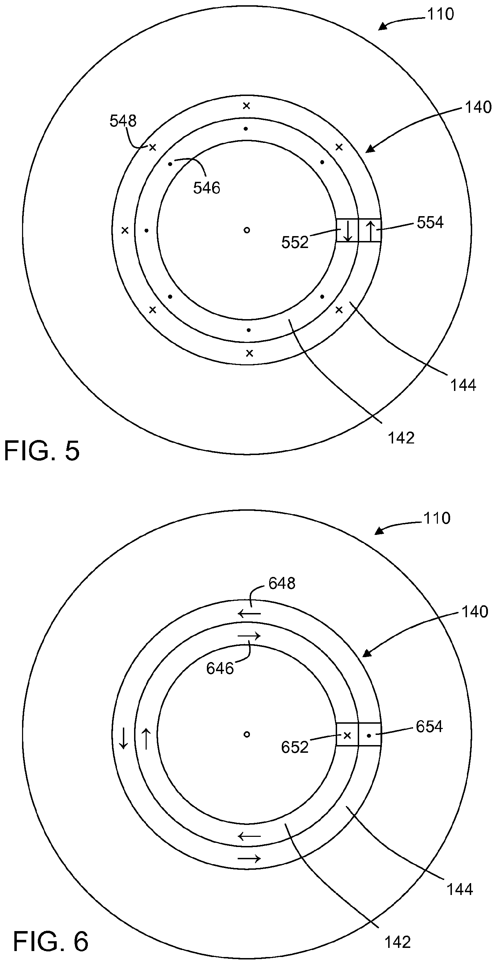

Turning to FIG. 5, shown therein is a top plan view of the disk 110 in the quiescent state, with a magnetoelastically active region 140 created by permanent magnets 202, 204 as shown in FIG. 2. The magnetoelastically active region 140 includes dual magnetically conditioned regions 142, 144 that are oppositely polarized in positive and negative axial directions, respectively. The dots in FIG. 5 indicate magnetic field lines 546 oriented perpendicular to the surface of the disk 110, such that the magnetic field lines 546 are directed out of the page. The X's in FIG. 5 indicate magnetic field lines 548 oriented perpendicular to the surface of the disk 110, such that the magnetic field lines 548 are directed into the page.

In an example not forming part of the current invention, a pair of magnetic field sensors 552, 554 is positioned proximate to the magnetoelastically active region 140, such that each magnetic field sensor 552, 554 is placed over the portion of the magnetically conditioned region 142, 144 at a location where the magnetic field strength is at a maximum. The magnetic field sensors 552, 554 are oriented such that their sensitive directions are perpendicular to the direction of magnetization in the magnetoelastically active region 140. In FIG. 5, arrows indicate the sensitive directions of the magnetic field sensors 552, 554. Magnetic field sensors 552, 554 are oriented with their sensitive directions parallel to the surface of the disk 110 (i.e., in the circumferential direction), and the magnetically conditioned regions 142, 144 are polarized perpendicular to the surface of the disk 110 (i.e., in the axial direction). This configuration ensures that the representative signals outputted by the magnetic field sensors 552, 554 vary linearly with respect to variations in the torque applied to the disk 110.

Magnetic field sensors 552, 554 are oppositely polarized and provided in pairs. This placement technique may be referred to as a common mode rejection configuration. Output signals from each of the magnetic field sensors 552, 554 in the pair may be summed to provide a signal representative of the torque applied to the disk 110. External magnetic fields have equal effects on each of the magnetic field sensors 552, 554 in the pair. Because the magnetic field sensors 552, 554 in the pair are oppositely polarized, the summed output of the magnetic field sensors 552, 554 is zero with respect to external magnetic fields. However, because the magnetically conditioned regions 142, 144 are oppositely polarized, as are the magnetic field sensors 552, 554, the summed output of the magnetic field sensors 552, 554 is double that of each individual magnetic field sensor 552, 554 with respect to the torque applied to the disk 110. Therefore, placing magnetic field sensors 552, 554 in a common mode rejection configuration greatly reduces the detrimental effects of compassing in the torque sensing device.

Turning to another example, not forming part of the current invention, shown in FIG. 6, the disk 110 is shown in the quiescent state, and has a magnetoelastically active region 140 created by permanent magnets 302, 304 as shown in FIG. 3. The magnetoelastically active region 140 includes dual magnetically conditioned regions 142, 144 that are oppositely polarized, with magnetic field lines 646, 648, in opposite circumferential directions. A pair of magnetic field sensors 652, 654 may be positioned proximate to the magnetoelastically active region 140, such that each magnetic field sensor 652, 656 is placed over the portion of a magnetically conditioned region 142, 144 at a location where the magnetic field strength is at a maximum. The magnetic field sensors 652, 654 are oriented such that their sensitive directions are perpendicular to the direction of magnetization in the magnetoelastically active region 140. In FIG. 6, a dot (indicating a direction out of the page) and an X (indicating a direction into the page) indicate the sensitive directions of the magnetic field sensors 652, 654. Magnetic field sensors 652, 654 are oriented with their sensitive directions perpendicular to the surface of the disk 110 (i.e., in the axial direction), and magnetically conditioned regions 142, 144 are polarized parallel to the surface of the disk 110 (i.e., in the circumferential direction) to ensure that the representative signals outputted by the magnetic field sensors 652, 654 vary linearly with respect to variations in the torque applied to the disk 110. Magnetic field sensors 652, 654 are placed in a common mode rejection configuration to reduce the effects of compassing in the torque sensing device.

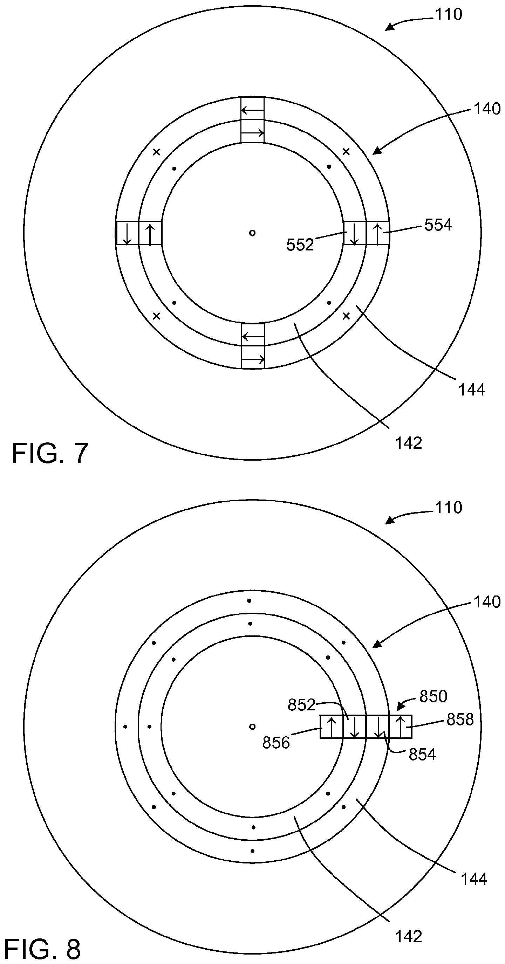

Turning to an embodiment of the current invention, shown in FIG. 7, shown therein is the disk 110 having a magnetoelastically active region 140 with dual magnetically conditioned regions 142, 144, which are polarized in opposite axial directions. Four pairs of magnetic field sensors 552, 554 are positioned proximate to the magnetoelastically active region 140 with their sensitive directions perpendicular to the magnetization of the magnetically conditioned regions 142, 144. The four pairs of magnetic field sensors 552, 554 are evenly spaced about the magnetoelastically active region 140 with approximately 90 degrees between each pair. This configuration provides for improved RSU performance because it allows for representative signals outputted by the multiple magnetic field sensors 552, 554 to be averaged, thereby resulting in a more accurate measurement of the torque applied to the disk 110. Any inaccuracies attributable to a single magnetic field sensor pair due to non-uniformities in the magnetoelastically active region 140 are of reduced significance when the representative signals from multiple magnetic field sensors 552, 554 are averaged. In torque sensing devices having magnetoelastically active regions 140 that exhibit a high degree of uniformity (i.e., RSU signal is substantially zero), as few as one pair of magnetic field sensors 552, 554 may be used to achieve sufficient RSU performance. However, due to limitations in material preparation and magnetization processes, a significant non-zero RSU signal may be difficult to avoid. In instances in which increased RSU performance is desired, the number of magnetic field sensor pairs may be increased. For example, eight pairs of magnetic field sensors 552, 554, spaced at 45 degrees, may be used.

Turning to another example shown in Fig. 8, not forming part of the current invention, shown therein is the disk 110 having a magnetoelastically active region 140 with magnetically conditioned regions 142, 144 polarized in a single axial direction to form, essentially, a single magnetically conditioned region. A magnetic field sensor unit 850 includes four individual magnetic field sensors 852, 854, 856, 858. Primary magnetic field sensors 852, 854 are positioned proximate to the magnetoelastically active region 140, are aligned in the radial direction, and are similarly polarized in a direction perpendicular to the magnetization of the magnetoelastically active region 140. Secondary magnetic field sensors 856, 858 are positioned on opposite sides of the primary magnetic field sensors 852, 854, proximate to the disk 110, but apart from the magnetoelastically active region 140, such that the secondary magnetic field sensors 856, 858 do not pick up torque induced signals. The secondary magnetic field sensors 856, 858 are similarly polarized in a direction opposite that of the primary magnetic field sensors 852, 854. This configuration may be advantageous in instances in which a noise source (not shown) creates a local magnetic field gradient having different effects on each of the primary magnetic field sensors 852, 854, as discussed in U.S. Pat. App. Pub. No. 2009/0230953 to Lee. In such an instance, it may be assumed that the noise source has the greatest effect on the secondary magnetic field sensor 856, 858 closest to the noise source, and the least effect on the secondary magnetic field sensor 858, 856 farthest from the noise source. It may also be assumed that the effect of the noise source on the primary magnetic field sensors 852, 854 is between that of its effects on each of the secondary magnetic field sensors 856, 858. Finally, it may be assumed that the sum of the noise induced signals picked up by the secondary magnetic field sensors 856, 858 is equal in value to the sum of the noise induced signals picked up by the primary magnetic field sensors 852, 854. Therefore, by summing the signals picked up by each of the four magnetic field sensors 852, 854, 856, 858, the effect of magnetic noise on the magnetic field sensor unit 850 is canceled, and the composite signal picked up by the magnetic field sensor unit 850 is entirely torque induced.

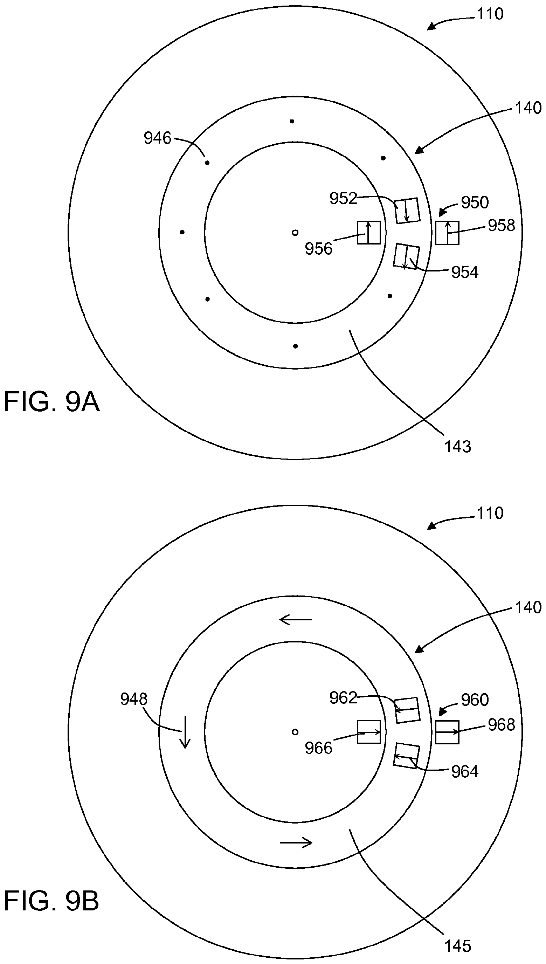

FIG. 9A shows a further configuration of the disk 110, not forming part of the current invention, that may be advantageous in situations in which the radial space on the disk 110 is limited. The disk 110 has a magnetoelastically active region 140 with a single magnetically conditioned region 143 polarized in a single axial direction. The dots in FIG. 9A indicate magnetic field lines 946 oriented perpendicular to the surface of the disk 110, such that the magnetic field lines 946 are directed out of the page. A magnetic field sensor unit 950 includes four individual magnetic field sensors 952, 954, 956, 958. Primary magnetic field sensors 952, 954 are positioned proximate to the magnetoelastically active region 140, are aligned in the circumferential direction, and are similarly polarized in a direction perpendicular to the magnetization of the magnetoelastically active region 140. Secondary magnetic field sensors 956, 958 are positioned on opposite sides of the primary magnetic field sensors 952, 954, proximate to the disk 110, but apart from the magnetoelastically active region 140, such that the secondary magnetic field sensors 956, 958 do not pick up torque induced signals. The secondary magnetic field sensors 956, 958 are similarly polarized in a direction opposite that of the primary magnetic field sensors 952, 954. This configuration may be advantageous in instances in which a noise source (not shown) creates a local magnetic field gradient having different effects on each of the primary magnetic field sensors 952, 954, as discussed in U.S. Pat. App. Pub. No. 2009/0230953 to Lee. In such an instance, it may be assumed that the noise source has the greatest effect on the secondary magnetic field sensor 956, 958 closest to the noise source, and the least effect on the secondary magnetic field sensor 958, 956 farthest from the noise source. It may also be assumed that the effect of the noise source on the primary magnetic field sensors 952, 954 is between that of its effects on each of the secondary magnetic field sensors 956, 958. Finally, it may be assumed that the sum of the noise induced signals picked up by the secondary magnetic field sensors 956, 958 is equal in value to the sum of the noise induced signals picked up by the primary magnetic field sensors 952, 954. Therefore, by summing the signals picked up by each of the four magnetic field sensors 952, 954, 956, 958, the effect of magnetic noise on the magnetic field sensor unit 950 is canceled, and the composite signal picked up by the magnetic field sensor unit 950 is entirely torque induced.

FIG. 9B shows another example, not forming part of the current invention, which is similar to that shown in FIG. 9A. In FIG. 9B, the disk 110 has a magnetoelastically active region 140 with a single magnetically conditioned region 145 polarized in a single circumferential direction. The arrows in Fig. 9B indicate magnetic field lines 948 oriented in the circumferential direction. A magnetic field sensor unit 960 includes four individual magnetic field sensors 962, 964, 966, 968. Primary magnetic field sensors 962, 964 are positioned proximate to the magnetoelastically active region 140, are aligned in the radial direction, and are similarly polarized in a direction perpendicular to the magnetization of the magnetoelastically active region 140. Secondary magnetic field sensors 966, 968 are positioned on opposite sides of the primary magnetic field sensors 962, 964, proximate to the disk 110, but apart from the magnetoelastically active region 140, such that the secondary magnetic field sensors 966, 968 do not pick up torque induced signals. The secondary magnetic field sensors 966, 968 are similarly polarized in a direction opposite that of the primary magnetic field sensors 962, 964. In a manner similar to that explained with respect to FIG. 9A, by summing the signals picked up by each of the four magnetic field sensors 962, 964, 966, 968, the effect of magnetic noise on the magnetic field sensor unit 960 is canceled, and the composite signal picked up by the magnetic field sensor unit 960 is entirely torque induced.

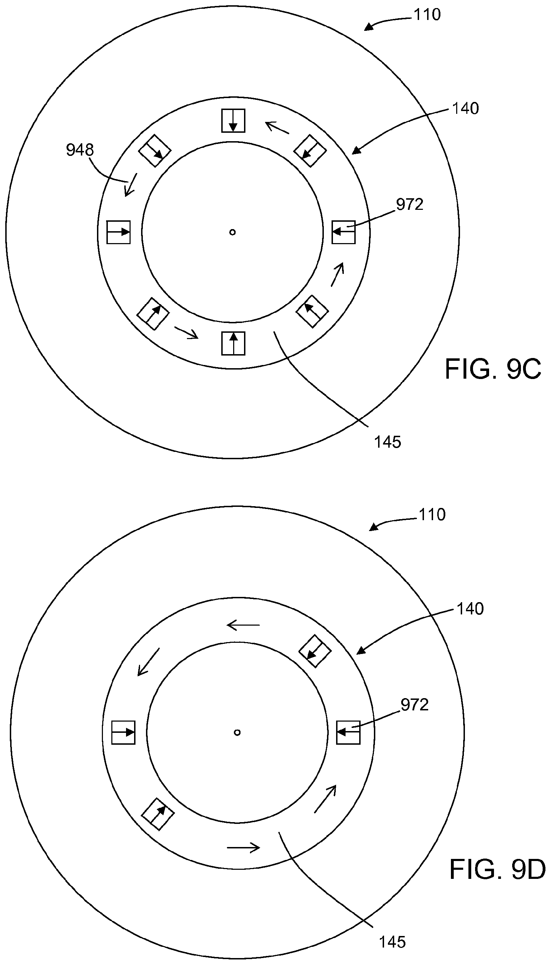

FIG. 9C shows another configuration of the disk 110, not forming part of the current invention, that may be advantageous in situations in which the radial space on the disk 110 is limited. The disk 110 has a magnetoelastically active region 140 with a single magnetically conditioned region 145 polarized in a single circumferential direction. The arrows in Fig. 9C indicate magnetic field lines 948 oriented in the circumferential direction. Magnetic field sensors 972 are positioned in a non-contact manner proximate to the magnetoelastically active region 140 and oriented such that their sensitive directions are perpendicular to the direction of magnetization in the magnetoelastically active region 140. Preferably, the distance between each of the magnetic field sensors 972 and the disk is not greater than about 5 mm.

In the configuration shown in FIG. 9C, eight magnetic field sensors 972 are evenly spaced about the magnetoelastically active region 140, each in a non-contact manner. The magnetic field sensors 972 are positioned with their sensitive directions oriented in the radial direction (i.e., perpendicular to the direction of magnetization), toward the center of the disk 110.

As with the configuration shown in FIG. 7, for example, the configuration of FIG. 9C provides for improved RSU performance because it allows for representative signals outputted by the multiple magnetic field sensors 972 to be averaged, thereby resulting in a more accurate measurement of the torque applied to the disk 110.

Furthermore, the configuration of FIG. 9C provides for common mode rejection, without requiring pairs of adjacent magnetic field sensors. Common mode rejection is achieved because of the symmetrical arrangement of the magnetic field sensors 972 about the disk 110. The magnetic field sensors 972 are symmetrically arranged, such that each magnetic field sensor 972 corresponds to another magnetic field sensor 972 having an opposite alignment. Corresponding magnetic field sensors 972, therefore, are oppositely polarized and spaced by 180 degrees. Common mode signals sensed by both of the corresponding magnetic field sensors 972, are thereby canceled. In FIG. 9C, the magnetic field sensors 972 are shown having sensitive directions that are each oriented radially, toward the center of the disk 110. Alternatively, for example, the magnetic field sensors 972 may have sensitive directions that are each oriented radially, away from the center of the disk 110.

FIG. 9C shows a disk 110 having eight magnetic field sensors 972; however, similar results may be achieved with any even number of symmetrically arranged magnetic field sensors 972. FIG. 9D shows an example of a disk 110, not forming part of the current invention, having four symmetrically arranged magnetic field sensors 972. The exact placement of the magnetic field sensors 972 may be adapted to suit the application for which they are desired. For example, the angular spacing between corresponding symmetrically arranged magnetic field sensors 972 may be slightly less than 180 degrees when such placement is necessary due to the geometric structure of the disk 110 and/or magnetic field sensors 972.

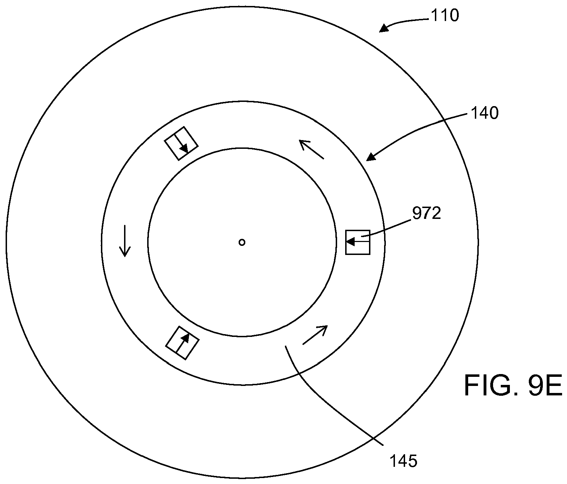

Turning to another example, not forming part of the current invention, shown in FIG. 9E, similar results may also be achieved using any number, greater than one, of magnetic field sensors 972 having sensitive directions that are each oriented radially, perpendicular to the direction of magnetization in the magnetoelastically active region 140, by evenly spacing the magnetic field sensors 972 about the magnetically active region 140. For example, if three magnetic field sensors 972 are radially aligned and evenly spaced by 120 degrees about the magnetically active region, common mode signals sensed by each of the magnetic field sensors 972 are canceled when the output signals from each of the magnetic field sensors 972 are summed.

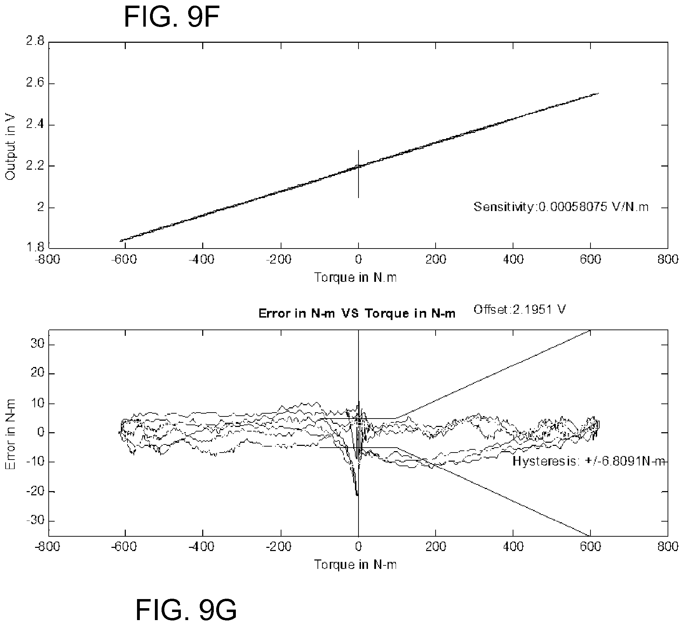

FIGS. 9F and 9G show experimental data obtained from tests performed on a disk formed of AISI 9310 material, having a configuration as shown in FIG. 9C. The experimental data shown in FIG. 9F indicates that the output of the magnetic field sensors 972 varies linearly with respect to torque applied to the disk 110. The experimental data shown in FIG. 9G indicates that hysteresis exhibited by the torque sensing device during operation is low, about ± 1%.

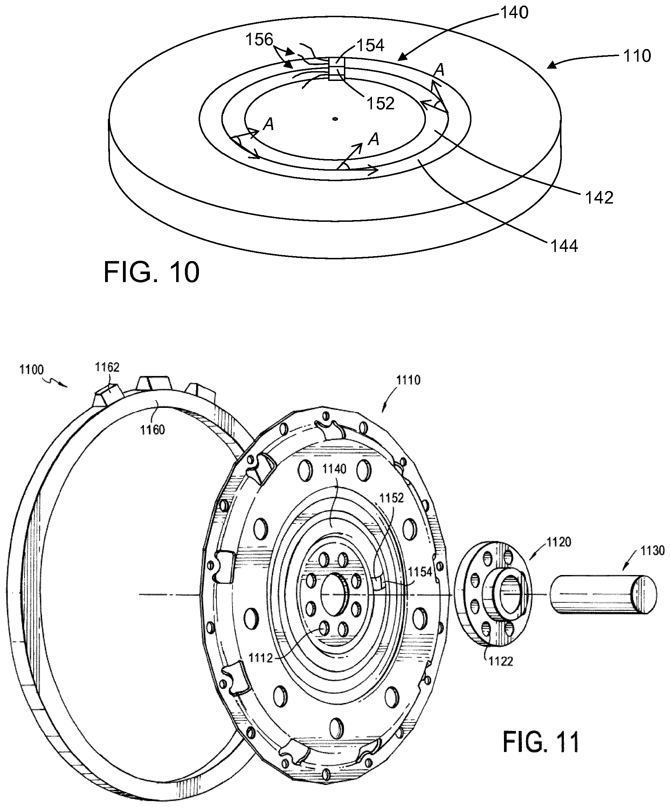

FIG. 10 provides an illustration of the principle by which torque applied to the disk 110 is measured by the torque sensing device. As discussed above, in the quiescent state, the magnetic fields in the magnetoelastically active region 140 are aligned either substantially exclusively in the axial direction, as shown in FIG. 5, or substantially exclusively in the circumferential direction, as shown in FIG. 6. When torque is applied to the disk 110, magnetic moments in the magnetoelastically active region 140 tend to tilt along the shear stress direction, which forms an angle of about 45 degrees with respect to the surface of the disk 110, as indicated by arrows A in FIG. 10. This tilt causes the magnetization of the magnetoelastically active region 140 to exhibit a decreased component in the initial direction, and an increased component in the shear stress direction. The degree of tilt is proportional to the strength of the torque applied to the disk 110. The magnetic field sensors 152, 154 are capable of sensing changes in the strength of magnetic field components along the sensitive directions of the magnetic field sensors 152, 154. Therefore, when torque is applied to the disk 110, magnetic field sensors 152, 154 output representative signals that are proportional to the applied torque.

Magnetic field sensors 152, 154 are known in the art and include magnetic field vector sensor devices such as flux-gate inductors, Hall Effect sensors, and the like. Preferably, the magnetic field sensors according to the present invention are flux-gate inductors having a solenoidal form. In another embodiment, the magnetic field sensors 152, 154 may be integrated circuit Hall Effect sensors. Conductors 156, as shown in FIG. 10, connect the magnetic field sensors to a source of direct current power, and transmit the signal output of the magnetic field sensors 152, 154 to a receiving device (not shown), such as a control or monitoring circuit.

Turning to FIG. 11, shown therein is a perspective, exploded view drawing of a torque transducer 1100 in accordance with the present invention, but in which, for the purposes of illustration, only one sensor pair 1152, 1154 is shown. In the exemplary embodiment shown, the torque transducer 1100 includes a disk 1110, a hub 1120, and a shaft 1130. The disk 1110, the hub 1120, and the shaft 1130 may be, but are not necessarily, distinct elements. The disk 1110 may be an axially thin, generally disk-shaped member, which may be completely flat or may include contours. The hub 1120 functions by rigidly attaching the disk 1110 to the shaft 1130. Attachment may be accomplished, for example, directly or indirectly by any known means which permits the hub 1120 and the shaft 1130 to act as a mechanical unit such that torque applied to the shaft 1130 is proportionally transmitted to the hub 1120 and vice versa. Examples of means of attachment include pins, splines, keys, welds, adhesives, press or shrink fits, and the like. The disk 1110 may be attached to the hub 1120 by any appropriate method which permits the disk 1110 and the hub 1120 to act as a mechanical unit such that torque applied to the hub 1120 is proportionally transmitted to the disk 1110, and vice versa. Preferably, holes 1112, 1122 are provided in the disk 1110 and the hub 1120 such that holes 1112 in the disk 1110 correspond to holes 1122 in the hub 1120. Fasteners (not shown), such as bolts, may be inserted through holes 1112 in the disk 1110 and corresponding holes 1122 in the hub 1120 such that a firm attachment is formed between the disk 1110 and the hub 1120. Examples of alternative means of attachment include riveting, welding, and the like.

The disk 1110 may be attached to a rim 1160, such that a portion of the disk 1110 attached to the rim 1160 is radially distinct from a portion of the disk 1110 attached to the hub 1120. The rim 1160 may surround the periphery of the disk 1110, or may be attached to a surface of the disk 1110. The rim 1160 may be an integral part of the disk 1110. The disk 1110 and the rim 1160 act as a mechanical unit such that torque applied to the disk 1110 may be proportionally transmitted to the rim 1160, and vice versa. The rim 1160 may include force transfer features 1162 for the transfer of predominately tangential forces to a driving or driven member.

An exemplary embodiment of the invention is a torque sensing device for use in connection with an automobile engine wherein the disk 1110 includes a drive plate, the shaft 1130 includes a crankshaft, and the rim 1160 includes a torque converter. It will be apparent to those skilled in the art to which the invention pertains, however, that the invention is not limited to any specific type of automobile configuration, nor is the invention limited to automotive applications in general.

The rim 1160 and the hub 1120 are preferably formed of non-ferromagnetic materials or are magnetically isolated from the disk 1110 by non-ferromagnetic spacers, such as low permeability rings (not shown) inserted between the hub 1120 and the disk 1110, and between the disk 1110 and the rim 1160.

The magnetoelastically active region 1140 must possess sufficient anisotropy to return the magnetization to the quiescent, or initial direction when the applied torque is reduced to zero. Magnetic anisotropy may be induced by physical working of the material of the disk 1110 or by other methods. Illustrative methods for inducing magnetic anisotropy are disclosed in U.S. Pat. No. 5,520,059.

Preferably, the disk 1110 is formed from AISI 9310 material. Examples of alternative materials from which the disk may be formed are described in U.S. Pat. No. 5,520,059 and U.S. Pat. No. 6,513,395. The disk 1110 may be formed of a material having a particularly desirable crystalline structure.

In another embodiment of the present invention, the magnetoelastically active region 1140 may be formed separately from the disk 1110, and then applied to the disk 1110 by means such as adhesives, welds, fasteners, or the like, such that torque induced in the disk 1110 is transmitted to and proportional to torque induced in the magnetoelastically active region 1140.

In the operation of the present invention, magnetic fields arise from the magnetoelastically active region 1140 and these fields pervade not only the space in which the magnetic field sensors 1152, 1154 are located but also the space occupied by the disk 1110 itself. Magnetization changes that take place within non-active portions of the disk 1110 may result in the formation of parasitic magnetic fields that may pervade the regions of space where the magnetic field sensors 1152, 1154 are located. The hub 1120 and the rim 1160 can be formed of non-ferromagnetic materials to reduce or eliminate parasitic magnetic fields. Thus, in the interest of not corrupting the transfer function of the magnetoelastically active region 1140, it is important that the parasitic fields be very small, ideally zero, in comparison with the magnetic field arising from the magnetoelastically active region or, if of significant intensity, that they change linearly and anhysteretically (or not at all) with applied torque, and that they be stable with time and under any of the operational and environmental conditions that the shaft 1130, the disk 1110, and the magnetoelastically active region 1140 might be subjected to. Stated otherwise, any parasitic fields which arise must be sufficiently small compared to the magnetoelastically active region field such that the net field seen by the magnetic field sensors 1152, 1154 is useful for torque sensing purposes. Thus, in order to minimize the corrupting influence of parasitic fields, it is important to utilize a disk material having a coercivity sufficiently high that the field arising from the magnetoelastically active region 1140 does not magnetize regions of the disk 1110 proximate to the magnetoelastically active region 1140 to give rise to such parasitic magnetic fields which are of sufficient strength to destroy the usefulness, for torque sensing purposes, of the net magnetic field seen by the magnetic field sensors 1152, 1154. This may be accomplished, for example, by using a material in which the coercivity of the disk 1110 is greater than 15 Oe, preferably greater than 20 Oe, and most desirably greater than 35 Oe.

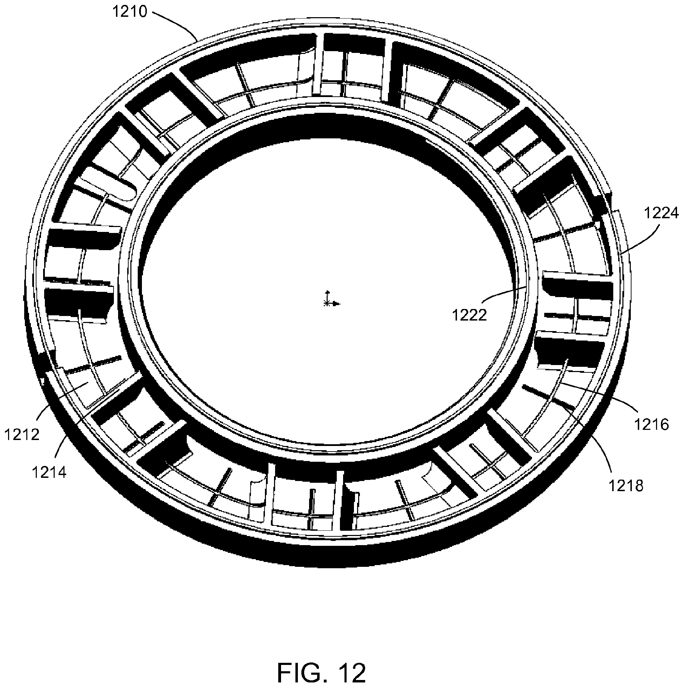

Turning to FIG. 12, shown therein is an exemplary bobbin 1210 for use with the present invention. Preferably, when used with a torque transducer 1100 as shown, for example, in FIG. 11, the bobbin 1210 is commensurate with the magnetoelastically active region 1140, and is positioned proximate to the disk 1110 such that the entirety of the bobbin 1210 is proximate the magnetoelastically conditioned region 1140. Accordingly, the bobbin 1210 is annularly shaped with a width approximately equal to that of the magnetoelastically active region 1140. The bobbin 1210 may be attached to the disk 1110 by any suitable attachment means.

The bobbin 1210 provides a housing for the magnetic field sensors 1152, 1154, which may be positioned according to any of the embodiments of the present invention. Preferably, the bobbin 1210 is formed of a non-magnetic plastic material. The bobbin 1210 may contain several compartments 1212 at which magnetic field sensors 1152, 1154 may be positioned. Separators 1214 may be provided between each of the compartments 1212. The exemplary bobbin of FIG. 12 includes an annular groove 1216 corresponding to the center of the magnetoelastically active region 1140, and radially extending grooves 1218, corresponding to locations at which magnetic field sensors 1152, 1154 may be placed. The magnetic field sensors 1152, 1154 may be attached to the bobbin 1210 by any suitable attachment means.

To further reduce the negative effects of parasitic magnetic fields, the bobbin 1210 may include shielding members 1222, 1224 disposed thereon. Preferably, the bobbin 1210 includes both an inner shielding member 1222 and an outer shielding member 1224 that are annularly shaped with radii corresponding to the inner and outer radii of the magnetoelastically active region 1140, respectively. The bobbin 1210 may include annular channels in which the shielding members 1222, 1224 may be received. Preferably, the shielding members 1222, 1224 have heights of approximately 6 mm (measured in the axial direction) and thicknesses of 1 mm (measured in the radial direction). To provide adequate magnetic shielding (i.e., to ensure that the magnetic field sensors 1152, 1154 only sense magnetic fields generated within the magnetoelastically active region 1140), the shielding members 1122, 1124 are preferably formed of a material exhibiting high magnetic permeability, such as mu-metal.

During operation of the torque transducer 1100, magnetic field lines are likely to accumulate about the boundaries between materials having significantly different magnetic permeabilities, particularly at the holes 1112, where the disk material forms a boundary with the air. The shielding members 1122, 1124 ensure that such accumulation does not affect the magnetic field sensors 1152, 1154.

In addition to torque, the present invention is capable of measuring power, energy, or rotational speed, wherein

$$\text{Power} = \text{Torque} \times 2\pi \times \text{Rotational Speed},$$

and

$$\text{Energy} = \text{Power} / \text{Time}.$$

Although certain presently preferred embodiments of the disclosed invention have been specifically described herein, it will be apparent to those skilled in the art to which the invention pertains that variations and modifications of the various embodiments shown and described herein may be made without departing from the scope of the invention. Accordingly, it is intended that the invention be limited only the extent required by the appended claims and the applicable rules of law.

**Claims**

1. A magnetic torque sensing device comprising:

a generally disk-shaped member (110) having opposite generally circular spaced apart surfaces, and forming a central axis (O) of rotation; a radially-extending magnetostrictive magnetically conditioned region (143) disposed on or in at least a portion of the disk-shaped member forming a magnetoelastically active region (140) for producing a magnetic field that varies with a torque applied to the disk-shaped member, wherein the magnetically active region is annularly shaped and possesses sufficient magnetic anisotropy to return the magnetization in the magnetoelastically active region to an initial state when the torque applied to the disk-shaped member is reduced to zero, wherein the magnetoelastically active region comprises at least two radially distinct, annular, oppositely polarized magnetically conditioned regions (142, 144) defining the magnetoelastically active region and wherein there is no radial gap between the two regions (142, 144); and a plurality of magnetic field sensor pairs (552, 554), each comprising a first (552) and a second (554) magnetic field sensor, disposed adjacent to one another and proximate to the magnetically conditioned region such that each magnetic field sensor is placed over a respective magnetically conditioned region, each of the magnetic field sensors of the sensor pair having a sensitive direction that is perpendicular to a direction of polarization of the magnetically conditioned region, wherein the magnetic field sensors of each pair are symmetrically arranged such that, for the first magnetic field sensor having its sensitive direction oriented in a first direction, the second corresponding magnetic field sensor has its sensitive direction oriented in a second direction, opposite the first direction, to cancel the effect of common mode noise sensed by the first and second magnetic field sensors, wherein the plurality of sensor pairs are evenly spaced angularly about the magnetoelastically active region, wherein the magnetic field sensors provide an output signal that is representative of the torque applied to the disk-shaped member, wherein variation in the output signal is substantially linear with respect to variation in the torque applied to the disk-shaped member, and wherein the magnetic torque sensing device further comprises a shielding member (1222) configured to provide magnetic shielding to at least some of the magnetic field sensors.

2. The magnetic torque sensing device, as claimed in claim 1 further comprising a second shielding member (1224) configured to provide magnetic shielding to at least some of the magnetic field sensors (152, 154), wherein the magnetically conditioned region (143) is bounded by an inner radius and an outer radius defining the magnetoelastically active region, wherein the first shielding member (1222) has a radius approximately equal to the inner radius of the magnetoelastically active region, and wherein the second shielding member has a radius approximately equal to the outer radius of the magnetoelastically active region.

3. The magnetic torque sensing device, as claimed in claim 2, wherein the first and second shielding member (1222, 1224) are formed of mu-metal and/or wherein the magnetic torque sensing device further comprises a bobbin (1210) having the first shielding member, the second shielding member, and the magnetic field sensors (152, 154) disposed thereon.

4. The magnetic torque sensing device, as claimed in claim 1, wherein the magnetically conditioned region (143) is initially polarized in an axial direction, and wherein the sensitive direction of each magnetic field sensor is oriented in a direction perpendicular to the magnetization of the magnetically conditioned region (143).

5. The magnetic torque sensing device, as claimed in claim 4, wherein the magnetic torque sensing device comprises at least four magnetic field sensor pairs (552, 554), angularly offset from one another or, wherein the magnetic torque sensing device comprises at least eight magnetic field sensor pairs (552, 554), angularly offset from one another.

6. The magnetic torque sensing device, as claimed in claim 4, wherein at least one magnetic field sensor unit (960) comprises a flux gate sensor and/or wherein at least one magnetic field sensor unit comprises a Hall Effect sensor and/or, wherein at least a portion of the disk-shaped member (110) is made from at least AISI 9310 material and/or wherein the disk-shaped member is formed of a material having a coercivity greater than 15 Oe, or greater than 20 Oe, or greater than 35 Oe and/or, wherein the disk-shaped member comprises a drive plate.

7. The magnetic torque sensing device, as claimed in claim 4, further comprising a torque transmitting element directly or indirectly attached to or forming a part of the disk-shaped member (110) at the central axis (O) of rotation in such a manner that torque applied to the torque transmitting element is proportionally transmitted between the torque transmitting element and the disk-shaped member.

8. The magnetic torque sensing device, as claimed in claim 7, wherein the torque transmitting element comprises a crankshaft.

**Patentansprüche**

1. Magnetische Drehmomentsensorvorrichtung mit:

   einem insgesamt scheibenförmigen Element (110), das zueinander entgegengesetzte insgesamt kreisförmige voneinander beabstandete Oberflächen aufweist und eine zentrale Rotationsachse (O) bildet, einem sich radial erstreckenden magnetostriktiven magnetisch konditionierten Bereich (143), der auf oder in wenigstens einem Teil des scheibenförmigen Elements angeordnet ist und einen magnetoelastisch aktiven Bereich (140) zur Erzeugung eines Magnetfelds bildet, das sich mit einem auf das scheibenförmige Element aufgebrachten Drehmoment ändert, wobei der magnetisch aktive Bereich ringförmig ausgebildet ist und eine magnetische Anisotropie besitzt, die dazu ausreicht, die Magnetisierung in dem magnetoelastisch aktiven Bereich in einen Anfangszustand zurückzuführen, wenn das auf das scheibenförmige Element aufgebrachte Drehmoment auf Null verringert wird, wobei der magnetoelastisch aktive Bereich wenigstens zwei radial verschiedene ringförmige entgegengesetzt polarisierte, magnetisch konditionierte Bereiche (142, 144) umfasst, die den magnetoelastisch aktiven Bereich definieren, und wobei zwischen den beiden Bereichen (142, 144) kein radialer Spalt vorhanden ist, und mehreren Magnetfeldsensorpaaren (552, 554), die jeweils einen ersten (552) und einen zweiten (554) Magnetfeldsensor umfassen, die aneinander angrenzend und nahe dem magnetisch konditionierten Bereich so angeordnet sind, dass jeder Magnetfeldsensor über einem jeweiligen magnetisch konditionierten Bereich gelegen ist, wobei jeder der Magnetfeldsensoren des Sensorpaares eine Empfindlichkeitsrichtung aufweist, die senkrecht zu einer Polarisationsrichtung des magnetisch konditionierten Bereichs ist, wobei die Magnetfeldsensoren jedes Paares symmetrisch angeordnet sind, derart, dass für den ersten Magnetfeldsensor, dessen Empfindlichkeitsrichtung in einer ersten Richtung ausgerichtet ist, die Empfindlichkeitsrichtung des zweiten entsprechenden Magnetfeldsensors in einer zweiten Richtung ausgerichtet ist, die zur ersten Richtung entgegengesetzt ist, um die Wirkung eines von dem ersten und dem zweiten Magnetfeldsensor erfassten Gleichtaktrauschens aufzuheben, wobei die mehreren Sensorpaare winkelmäßig gleichmäßig um den magnetoelastisch aktiven Bereich herum beabstandet sind,
wobei die Magnetfeldsensoren ein Ausgangssignal liefern, das für das auf das scheibenförmige Element aufgebrachte Drehmoment repräsentativ ist, wobei eine Veränderung des Ausgangssignals bezüglich einer Veränderung des auf das scheibenförmige Element aufgebrachten Drehmoments im Wesentlichen linear ist, und wobei die magnetische Drehmomentsensorvorrichtung ferner ein Abschirmelement (1222) umfasst, das so eingerichtet ist, dass es für wenigstens einige der Magnetfeldsensoren eine magnetische Abschirmung bietet.

2. Magnetische Drehmomentsensorvorrichtung nach Anspruch 1, ferner mit einem zweiten Abschirmelement (1224), das so eingerichtet ist, dass es für wenigstens einige der Magnetfeldsensoren (152, 154) eine magnetische Abschirmung bietet,
wobei der magnetisch konditionierte Bereich (143) durch einen Innenradius und einen Außenradius begrenzt ist, die den magnetoelastisch aktiven Bereich definieren,
wobei das erste Abschirmelement (1222) einen Radius hat, der annähernd gleich dem Innenradius des magnetoelastisch aktiven Bereichs ist, und wobei das zweite Abschirmelement einen Radius hat, der annähernd gleich dem Außenradius des magnetoelastisch aktiven Bereichs ist.

3. Magnetische Drehmomentsensorvorrichtung nach Anspruch 2, wobei das erste und das zweite Abschirmelement (1222, 1224) aus Mu-Metall gebildet sind und/oder wobei die magnetische Drehmomentsensorvorrichtung ferner einen Spulenkörper (1210) umfasst, auf dem das erste Abschirmelement, das zweite Abschirmelement und die Magnetfeldsensoren (152, 154) angeordnet sind.

4. Magnetische Drehmomentsensorvorrichtung nach Anspruch 1, wobei der magnetisch konditionierte Bereich (143) anfangs in einer Axialrichtung polarisiert ist und wobei die Empfindlichkeitsrichtung jedes Magnetfeldsensors in einer zur Magnetisierung des magnetisch konditionierten Bereichs (143) senkrechten Richtung ausgerichtet ist.

5. Magnetische Drehmomentsensorvorrichtung nach Anspruch 4, wobei die magnetische Drehmomentsensorvorrichtung mindestens vier Magnetfeldsensorpaare (552, 554) umfasst, die winkelmäßig gegeneinander versetzt sind, oder wobei die magnetische Drehmomentsensorvorrichtung mindestens acht Magnetfeldsensorpaare (552, 554) umfasst, die winkelmäßig gegeneinander versetzt sind.

6. Magnetische Drehmomentsensorvorrichtung nach Anspruch 4, wobei wenigstens eine Magnetfeldsensoreinheit (960) ein Luftspaltmagnetometer umfasst und/oder wobei wenigstens eine Magnetfeldsensoreinheit einen Hall-Sensor umfasst und/oder wobei wenigstens ein Teil des scheibenförmigen Elements (110) aus wenigstens AISI 9310-Material besteht und/oder wobei das scheibenförmige Element aus einem Material mit einer Koerzitivfeldstärke von mehr als 15 Oe oder mehr als 20 Oe oder mehr als 35 Oe gebildet ist und/oder wobei das scheibenförmige Element eine Antriebsscheibe umfasst.

7. Magnetische Drehmomentsensorvorrichtung nach Anspruch 4, ferner mit einem Drehmoment übertragenden Element, das unmittelbar oder mittelbar an dem scheibenförmigen Element (110) an der zentralen Rotationsachse (O) derart befestigt ist oder einen Teil von diesem bildet, dass ein auf das Drehmoment übertragende Element aufgebrachtes Drehmoment proportional zwischen dem Drehmoment übertragenden Element und dem scheibenförmigen Element übertragen wird.

8. Magnetische Drehmomentsensorvorrichtung nach Anspruch 7, wobei das Drehmoment übertragende Element eine Kurbelwelle umfasst.

**Revendications**

1. Dispositif de détection de couple magnétique, comprenant :

un élément (110) généralement en forme de disque présentant des surfaces opposées généralement circulaires espacées les unes des autres et définissant un axe central de rotation (O), une zone magnétostrictive (143) conditionnée magnétiquement et s'étendant radialement, agencée sur ou dans au moins une partie de l'élément en forme de disque et formant une zone magnéto-élastiquement active (140) pour générer un champ magnétique qui varie avec un couple appliqué à l'élément en forme de disque, la zone magnétiquement active étant annulaire et présentant une anisotropie magnétique suffisante pour ramener la magnétisation dans la zone magnéto-élastiquement active à un état initial lorsque le couple appliqué à l'élément en forme de disque est réduit à zéro, la zone magnéto-élastiquement active comprenant au moins deux zones annulaires (142, 144) radialement distinctes, polarisées de manière opposée et conditionnées magnétiquement qui définissent la zone magnéto-élastiquement active, et un espace radial étant absent entre les deux zones (142, 144) ; et

une pluralité de paires de capteurs de champ magnétique (552, 554) comprenant chacune un premier (552) et un deuxième (554) capteur de champ magnétique agencés de manière adjacente l'un à l'autre et à proximité de la zone conditionnée magnétiquement, de sorte que chaque capteur de champ magnétique est situé au-dessus d'une zone conditionnée magnétiquement respective, chacun des capteurs de champ magnétique de la paire de capteurs présentant une direction de sensibilité qui est perpendiculaire à une direction de polarisation de la zone conditionnée magnétiquement,

les capteurs de champ magnétique de chaque paire étant agencés de manière symétrique de telle sorte que pour le premier capteur de champ magnétique dont la direction de sensibilité est orientée dans une première direction, la direction de sensibilité du deuxième capteur de champ magnétique correspondant est orientée dans une deuxième direction opposée à la première direction pour annuler l'effet du bruit de mode commun détecté par le premier et le deuxième capteur de champ magnétique, les plusieurs paires de capteurs étant angulairement espacées de manière régulière autour de la zone magnéto-élastiquement active,

les capteurs de champ magnétique fournissant un signal de sortie représentatif du couple appliqué à l'élément en forme de disque, une variation du signal de sortie étant sensiblement linéaire par rapport à une variation du couple appliqué à l'élément en forme de disque, et

le dispositif de détection de couple magnétique comprenant en outre un élément de blindage (1222) réalisé de manière à fournir un blindage magnétique pour au moins certains des capteurs de champ magnétique.

2. Dispositif de détection de couple magnétique selon la revendication 1, comprenant en outre un deuxième élément de blindage (1224) qui est réalisé de manière à fournir un blindage magnétique pour au moins certains des capteurs de champ magnétique (152, 154),

la zone conditionnée magnétiquement (143) étant délimitée par un rayon intérieur et un rayon extérieur définissant la zone magnéto-élastiquement active,

le premier élément de blindage (1222) présentant un rayon approximativement égal au rayon intérieur de la zone magnéto-élastiquement active, et

le deuxième élément de blindage présentant un rayon approximativement égal au rayon extérieur de la zone magnéto-élastiquement active.

3. Dispositif de détection de couple magnétique selon la revendication 2, le premier et le deuxième élément de blindage (1222, 1224) étant réalisés en mu-métal, et/ou le dispositif de détection de couple magnétique comprenant en outre une bobine (1210) sur laquelle le premier élément de blindage, le deuxième élément de blindage et les capteurs de champ magnétique (152, 154) sont agencés.

4. Dispositif de détection de couple magnétique selon la revendication 1, la zone conditionnée magnétiquement (143) étant initialement polarisée dans une direction axiale, et la direction de sensibilité de chaque capteur de champ magnétique étant orientée dans une direction perpendiculaire à la magnétisation de la zone conditionnée magnétiquement (143).

5. Dispositif de détection de couple magnétique selon la revendication 4, le dispositif de détection de couple magnétique comprenant au moins quatre paires de capteurs de champ magnétique (552, 554) décalées angulairement les unes par rapport aux autres, ou le dispositif de détection de couple magnétique comprenant au moins huit paires de capteurs de champ magnétique (552, 554) décalées angulairement les unes par rapport aux autres.

6. Dispositif de détection de couple magnétique selon la revendication 4, au moins une unité de capteur de champ magnétique (960) comprenant un capteur fluxgate, et/ou au moins une unité de capteur de champ magnétique comprenant un capteur à effet Hall, et/ou au moins une partie de l'élément en forme de disque (110) étant au moins réalisée à partir de matériau AISI 9310, et/ou l'élément en forme de disque étant formé d'un matériau présentant une intensité de champ coercitif supérieure à 15 Oe ou supérieure à 20 Oe ou supérieure à 35 Oe, et/ou l'élément en forme de disque comprenant une plaque d'entraînement.

7. Dispositif de détection de couple magnétique selon la revendication 4, comprenant en outre un élément de transmission de couple qui est directement ou indirectement fixé à l'élément en forme de disque (110) ou en fait partie au niveau de l'axe central de rotation (O), de sorte qu'un couple appliqué à l'élément de transmission de couple est transmis proportionnellement entre l'élément de transmission de couple et l'élément en forme de disque.

8. Dispositif de détection de couple magnétique selon la revendication 7, l'élément de transmission du couple comprenant un vilebrequin.

FIG. 1

O

202

204

N    S

112

140

110

d1 {

S    N

114

142

144

# FIG. 2

110

140

O
o

S    N

302

304

N    S

144

# FIG. 3

142

Magnetic field created by the paired magnets

FIG. 4A

FIG. 4B

FIG. 5

FIG. 6

FIG. 7

FIG. 8

FIG. 9A

FIG. 9B

FIG. 9C

FIG. 9D

FIG. 9E

## FIG. 9F

Sensitivity:0.00058075 V/N.m

Error in N-m VS Torque in N-m   Offset:2.1951 V

Hysteresis: +/-6.8091N-m

## FIG. 9G

FIG. 10

FIG. 11

FIG. 12

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 27569311
- US 4896544 A, Garshelis
- US 5351555 A
- US 5520059 A, Garshelis
- US 6047605 A, Garshelis
- US 6513395 B, Jones
- WO 0113082 A1, May
- US 20090230953, Lee
- US 20090230953 A, Lee